# EUROPEAN PATENT SPECIFICATION

(11) **EP 2 148 360 B1**
(45) Date of publication and mention of the grant of the patent: **22.01.2014**
(21) Application number: 08752425.2
(22) Date of filing: 08.05.2008
(51) Int. Cl.: H01L 21/306, H01L 21/3065, H01L 41/18, H01L 41/22, H03H 3/02

(54) **DRY ETCHING METHOD**
TROCKENÄTZVERFAHREN
PROCEDE DE GRAVURE A SEC

(30) Priority: 14.05.2007 JP 2007127789
(43) Date of publication of application: 27.01.2010
(73) Proprietor: Ulvac, Inc., Chigasaki-shi Kanagawa 253-8543 (JP)
(72) Inventor: MORIKAWA, Yasuhiro, Susono-shi Shizuoka 410-1231 (JP); SUU, Koukou, Susono-shi Shizuoka 410-1231 (JP); HAYASHI, Toshio, Susono-shi Shizuoka 410-1231 (JP); SATOU, Tadayuki, Susono-shi Shizuoka 410-1231 (JP)
(74) Representative: Epping - Hermann - Fischer
(86) International application number: PCT/JP2008/058534
(87) International publication number: WO 2008/143004

(56) References cited:
- JP-A- 11 150 133
- JP-A- 2002 059 363
- JP-A- 2005 101 110
- JP-A- 2007 053 189
- JP-A- 2007 096 756
- US-A1- 2005 036 267
- US-A1- 2005 178 741

## Description

### [Field of the Invention]

The present invention relates to a dry etching method.

### [Background Art]

In conventional dry etching apparatuses, electrostatic chucks and mechanical chucks have been used as mechanisms for fixing a substrate. One example of electrostatic chucks is a bipolar electrostatic chuck that includes an electrostatic chuck electrode. The electrostatic chuck electrode includes a circular first electrode and second electrodes. The second electrodes include a central electrode on the central side of the first electrode, corresponding to the central portion of a wafer, and a surrounding electrode outside the first electrode. A wafer is chucked on the top surface of the electrostatic chuck electrode by electrostatic forces generated between the first electrode and the second electrodes (see, for example, Japanese Patent Application Publication No. 10-125769, paragraph 0018 and Fig. 6). In this bipolar electrostatic chuck, helium gas is supplied to a narrow space between the wafer and the electrostatic chuck electrode to cool a substrate to be processed.

To meet recent demands for miniaturization of electronic devices and communication devices, in quartz oscillators (crystal oscillators) serving as key devices, ultrasmall quartz oscillators having a quartz element size of approximately 1.2 mm have been manufactured by photolithography and practically used. However, there is a demand for still finer quartz oscillators on the order of micrometers. It is known that quartz oscillators of such an order are formed by micromachining a quartz substrate by a dry etching method because quartz oscillators of such an order cannot be processed mechanically (see, for example, Japanese Patent Application Publication No. 2006-186847, claim 8 and Fig. 2). In this case, a substrate is etched on both sides or etched very deeply on one side to form a quartz oscillator.

US 2005/036267 refers to packaging of integrated circuit chips on one another or on wiring boards, which packaging requires previous thinning of a backside of a wafer or substrate. Thinning of a substrate backside, however, may cause scratches on the backside. US 2005/036267 suggests to remove scratches from the backside when the substrate is oriented, with its processed top side, down on a pedestal. US 2005/036267 thus refers to substrate backside etching after the backside has been thinned and after the integrated circuit has been formed on the substrate top side. With the integrated circuit already formed on the substrate, methods such as dry-etching are not applicable any more.

JP 2007-096756 A refers to a conventional dry-etching method in which a top side of a substrate is dry-etched when the substrate, with its backside, is placed directly on a substrate table arranged underneath the substrate. Only the top side of the substrate is dry-etched in JP 2007-096756 A.

### [Disclosure of Invention]

### [Problems to be Solved by the Invention]

When a substrate is continuously etched on both sides or etched very deeply on one side with an etching apparatus having an electrostatic chuck, as the thickness of the substrate to be processed decreases, the substrate has a decreased strength and is susceptible to temperature changes. Thus, a crack may form in the substrate. Furthermore, cooling helium gas present between the substrate and an electrostatic chuck electrode may leak from the crack.

It is an object of the present invention to provide a dry etching method for micromachining a substrate while the substrate is fixed so as not to form a crack even when the substrate is etched on both sides or etched very deeply on one side.

### [Means for Solving the Problems]

This object is solved by the dry etching method according to claim 1 which comprises:
- introducing an etching gas including a fluorocarbon gas and a rare gas into a vacuum chamber;
- generating plasma in the vacuum chamber having a predetermined pressure; and
- etching a substrate adhered on an adhesive surface of a heat-conductive sheet disposed on a substrate table which etching includes etching one side of the substrate;
- detaching the substrate from the heat-conductive sheet and reversing the substrate;
- adhering the one side on the adhesive surface of the heat-conductive sheet; and
- etching the other side of the substrate under substantially same conditions as conditions for the one side.
Fixing a substrate on a heat-conductive sheet allows the entire substrate to be uniformly supported and promotes heat conduction to the substrate, which facilitates control of the temperature of the substrate. Both sides of the substrate can therefore be etched without causing a crack.

The substrate is preferably detached from the heat-conductive sheet by heating or UV irradiation. Damage for the substrate can be reduced by detaching the substrate through such a process. Preferably, the substrate is a quartz substrate. Preferably, the heat-conductive sheet has a slit. The slit facilitates the detachment of the substrate from the heat-conductive sheet and decreases air bubbles under the heat-conductive sheet.

In etching, the flow rate of the rare gas preferably ranges from 80% to 95% of the total flow rate of the etching gas, and the rare gas is preferably at least one of Ar, Kr, and Xe. The flow rate of the rare gas below 80% of the total flow rate results in an excessively large number of active species, and etching cannot be performed as desired. The flow rate of the rare gas above 95% results in an excessively small number of active species, and etching cannot be performed sufficiently.

Preferably, the dry etching method is performed in a low-pressure process at 1 Pa or less. At a pressure above 1 Pa, radical reactions are difficult to prevent, making micromachining difficult.

The method of the invention may further comprise:
- fixing the heat-conductive sheet on a base before the substrate is adhered on the adhesive surface of the heat-conductive sheet, wherein the substrate is a quartz substrate;
- placing the base on the substrate table in the vacuum chamber before the etching gas including the fluorocarbon gas and the rare gas is introduced into the vacuum chamber;
- forming a magnetic neutral line while maintaining the internal pressure of the vacuum chamber at 1 Pa or less; and
- applying an electric field to generate plasma in the vacuum chamber before the one side of the quartz substrate is etched and the quartz substrate is detached from the heat-conductive sheet, before the other side is etched.

In etching of a quartz substrate fixed on a heat-conductive sheet using a dry etching apparatus that forms a magnetic neutral line and generates plasma, both sides of the substrate can be etched as desired with high-efficiency plasma while the entire substrate is uniformly supported.

In this case, preferably, the flow rate of the rare gas ranges from 80% to 95% of the total flow rate of the etching gas, the rare gas is at least one of Ar, Kr, and Xe, the heat-conductive sheet has a slit, and the substrate is detached from the heat-conductive sheet by heating or UV irradiation.

### [Effect of the Invention]

A dry etching method according to the present invention allows a substrate to be etched simply as desired without causing a crack in the substrate.

### [Best Modes for Carrying Out the Invention]

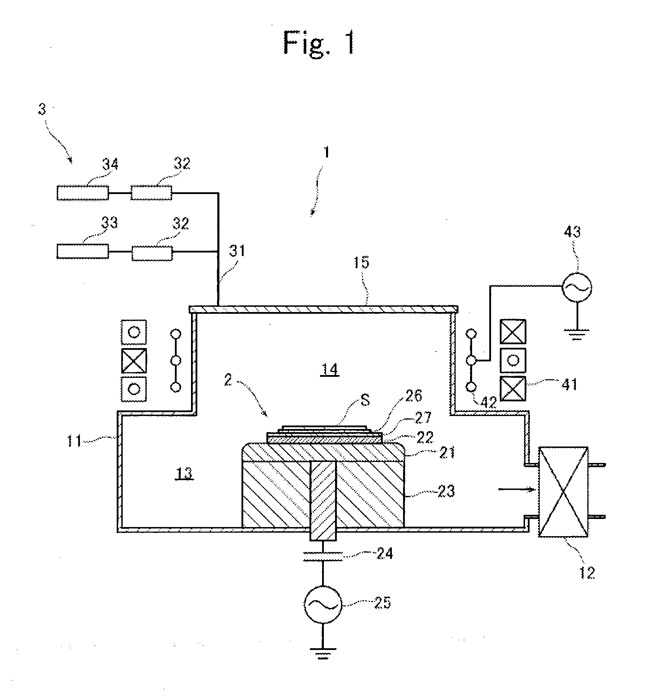

Fig. 1 illustrates an etching apparatus 1 used for performing a method for dry-etching an interlayer insulating film according to the present invention. The etching apparatus 1 includes a vacuum chamber 11 and can perform etching with low-temperature and high-density plasma. The vacuum chamber 11 is provided with evacuation means 12, such as a turbo-molecular pump.

The vacuum chamber 11 includes a lower substrate processing chamber 13 and an upper plasma generation chamber 14. A substrate table 2 is disposed at the center of the bottom of the substrate processing chamber 13. The substrate table 2 includes a substrate electrode 21, an electrostatic chuck electrode 22 disposed on the substrate electrode 21, and a support 23 for supporting the substrate electrode 21 and the electrostatic chuck electrode 22. The substrate electrode 21 is connected to a first high-frequency power source 25 via a blocking capacitor 24, acts as a floating electrode in terms of electric potential, and has negative bias potential. The electrostatic chuck electrode 22 may be a known electrostatic chuck electrode.

In the present invention, a base 27 on which a heat-conductive sheet 26 is placed is fixed with an electrostatic chuck electrode 22, and a substrate S to be processed is adhered on an adhesive surface of the heat-conductive sheet. Fixing the substrate S on the adhesive surface obviates the necessity of fixing the substrate S with an electrostatic chuck electrode, allowing the entire substrate S to be held stably and preventing the occurrence of a crack in the substrate. With such a structure, helium gas (not shown) in the electrostatic chuck electrode 22 has a cooling effect on the substrate S through the heat-conductive sheet 26, allowing the temperature of the substrate S to be controlled and preventing the occurrence of a crack in the substrate S.

Examples of the material of an adhesive layer in the heat-conductive sheet 26 include heat-conductive resins, for example, rubber, such as acrylic or isoprene isobutylene, or resins, such as silicone. The material of an adhesive layer may be any material provided that the adhesive layer can be detached by heating or UV irradiation. The heat-conductive sheet 26 has at least one heat-conductive adhesive surface.

A heat-conductive sheet 26 having a slit may be attached on the base 27. The slit facilitates the detachment of the heat-conductive sheet, and, in some cases, the slit prevents present the occurrence of a crack in the substrate due to the gas, such as air or an etching gas incorporated by evacuation, present between the heat-conductive sheet and the base (i.e., generation of gas bubbles). The shape of the slit may be not only linear, but also polygonal, circular, or a combination thereof. For example, in etching with a striped mask, preferably, a first slit is formed on a diagonal line of a substrate, and a second slit is formed in the direction of the stripes of the striped mask. After a heat-conductive sheet is fixed on the base, the heat-conductive sheet is preferably pressed with a rubber roller, a paddle, or a press machine to prevent such gas from being incorporated between the heat-conductive sheet and the base.

The substrate table 2 faces a top plate 15, which is disposed at the top of the plasma generation chamber 14 and is fixed to the sidewall of the plasma generation chamber 14. The top plate 15 is connected to a gas-inlet line 31 of gas-inlet means 3, which introduce an etching gas into the vacuum chamber 11. The gas-inlet line 31 has two branches, which lead to a rare gas source 33 and a fluorocarbon gas source 34 via gas-flow control means 32.

The top plate 15 may include a shower plate connected to the gas-inlet means 3.

The plasma generation chamber 14 has a cylindrical dielectric sidewall. A magnetic field coil 41 is disposed outside the sidewall as means for generating a magnetic field. The magnetic field coil 41 forms a magnetic neutral loop (not shown) in the plasma generation chamber 14.

A high-frequency antenna coil 42 for generating plasma is disposed between the magnetic field coil 41 and the outside of the sidewall of the plasma generation chamber 14. The high-frequency antenna coil 42 has a parallel antenna structure and constructed such that a voltage can be applied to the high-frequency antenna coil 42 by a second high-frequency power source 43. After a magnetic neutral line is formed by the magnetic field coil 41, an alternating electric field is applied along the magnetic neutral line to generate discharge plasma along the magnetic neutral line.

A mechanism for adjusting the voltage applied to the antenna coil to a predetermined voltage may be disposed.

An etching apparatus thus constituted has a simple structure and can form high-efficiency plasma without mutual interference of applied high-frequency electric fields.

An etching apparatus for performing a dry etching method according to the present invention may include a Faraday shield-like (or electrostatic field shield-like) floating electrode (not shown) inside the high-frequency antenna coil 42. The Faraday shield is a known Faraday shield and is, for example, a metal plate that has a plurality of parallel slits and an antenna coil intersecting the slits at right angles at the longitudinal midpoints of the slits. A metallic frame for equalizing the electric potential of a strip of metal plate is disposed at each longitudinal end of the slits. The metal plate can shield against an electrostatic field of the antenna coil 42 but cannot shield against an induction magnetic field. The induction magnetic field enters plasma and forms an induction electric field. The width of the slit can be appropriately determined for each purpose and ranges from 0.5 to 10 mm, preferably 1 to 2 mm. An excessively wide slit unfavorably causes the penetration of an electrostatic field. The slits may have a thickness of approximately 2 mm.

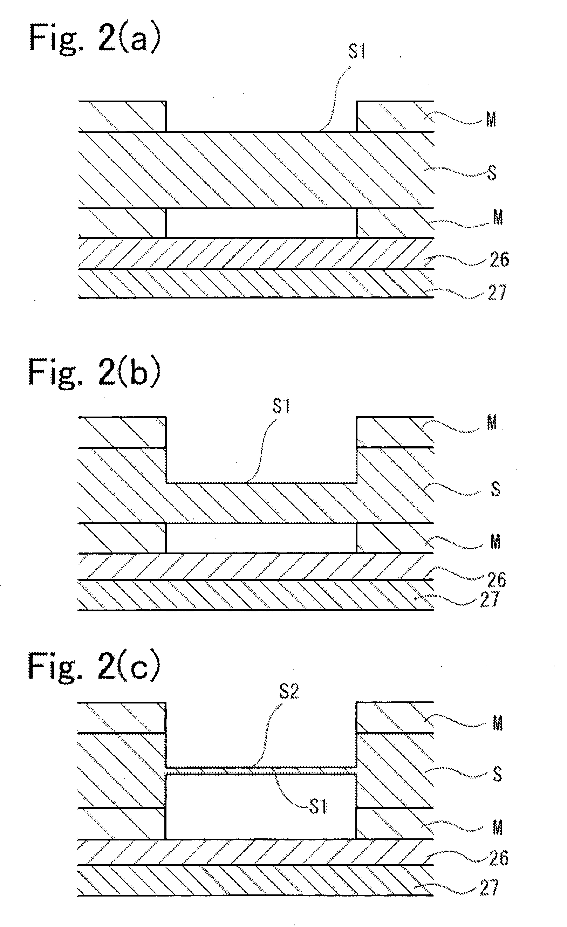

A method for etching a substrate S to be processed on both sides with the above-described etching apparatus 1 will be described below with reference to Figs. 1 and 2.

An object to be etched with the etching apparatus 1 is preferably a quartz substrate. A quartz substrate itself can be processed to manufacture, for example, a crystal oscillator on the order of micrometers, which has not been manufactured by conventional machining. A generally-used substrate on which a SiO₂ film, a film of a compound containing SiO₂, or a film formed of a material for optical elements is formed may be processed.

Examples of the compound containing SiO₂ include TEOS-SiO₂, phosphosilicate glass, borophosphosilicate glass, rare-earth-doped glass, and low-expansion crystallized-glass. Examples of the material for optical elements include lithium niobate, lithium tantalate, titanium oxide, tantalum oxide, and bismuth oxide.

The substrate may include a SiOCH material film formed by spin coating, such as HSQ or MSQ, a Low-k material film, which is formed of a SiOC material and is formed by CVD and has a relative dielectric constant in the range of 2.0 to 3.2, or a porous material film.

Examples of the SiOCH material include LKD5109r5 (trade name) manufactured by JSR Co., HSG-7000 (trade name) manufactured by Hitachi Chemical Co., Ltd., HOSP (trade name) manufactured by Honeywell Electric Materials, Nanoglass (trade name) manufactured by Honeywell Electric Materials, OCD T-12 (trade name) manufactured by Tokyo Ohka Kogyo Co., Ltd., OCD T-32 (trade name) manufactured by Tokyo Ohka Kogyo Co., Ltd., IPS2.4 (trade name) manufactured by Catalysts & Chemicals Industries Co., Ltd., IPS2.2 (trade name) manufactured by Catalysts & Chemicals Industries Co., Ltd., ALCAP-S5100 (trade name) manufactured by Asahi Kasei Co., and ISM (trade name) manufactured by ULVAC, Inc.

Examples of the SiOC material include Aurola2.7 (trade name) manufactured by ASM Japan K.K., Aurola2.4 (trade name) manufactured by ASM Japan K.K., Orion2.2 (trade name) manufactured by Fastgate Co. and Trikon Technologies Inc., Coral (trade name) manufactured by Novellus Systems Inc., Black Diamond (trade name) manufactured by Applied Materials, Inc. (AMAT), and NCS (trade name) manufactured by Fujitsu Ltd. Examples of the SiOC material also include SiLK (trade name) manufactured by The Dow Chemical Company, Porous-SiLK (trade name) manufactured by The Dow Chemical Company, FLARE (trade name) manufactured by Honeywell Electric Materials, Porous FLARE (trade name) manufactured by Honeywell Electric Materials, and GX-3P (trade name) manufactured by Honeywell Electric Materials.

As illustrated in Figs. 2(a) to 2(c), a mask M is formed on the substrate S to be etched. Examples of the material of the mask include organic materials, such as KrF resist materials and ArF resist materials, and known metallic materials, such as Ni.

The substrate S on which the mask M is formed is fixed on the adhesive surface of the heat-conductive sheet 26 disposed on the base 27 with a surface S1 facing upward (see Fig. 2(a)). The base 27 is placed on the electrostatic chuck electrode 22 in the vacuum chamber 11. An etching gas is then introduced from means 4 for introducing an etching gas, and RF power is applied by the second high-frequency power source 43 to generate plasma in the plasma generation chamber 14, thereby etching the surface S1 of the substrate S to be processed (see Fig. 2(b)). Etching of the substrate S on both sides further involves detaching the substrate S from the heat-conductive sheet 26 and reversing the substrate S, fixing the substrate S on the heat-conductive sheet 26 with a surface S2 facing upward, and etching the surface S2 under the substantially same conditions (see Fig. 2(c)). Thus, even when the substrate S has a very small thickness after etching of both sides, use of the heat-conductive sheet 26 prevents the occurrence of a crack in the substrate S, providing the substrate S etched as desired.

To detach a heat-conductive sheet by heating, the temperature may be increased with a hot plate, an air-heating furnace, or near-infrared rays to, for example, approximately 170°C at which the heat-conductive sheet can be detached.

Examples of the etching gas include gases that contain a fluorocarbon gas and at least one gas selected from rare gases, such as Ar, Xe, and Kr. Examples of the fluorocarbon gas include CF₄, C₂F₆, C₄F₈, and C₃F₈. In particular, C₄F₈ and C₃F₈ are preferred. In this case, the rare gas is introduced by the gas-flow control means 32 such that the rare gas constitutes 80% to 95% of the total flow rate of the etching gas. The etching gas is introduced in a plasma atmosphere into a vacuum chamber 11 at an operating pressure of 1.0 Pa or less and a flow rate of 100 to 300 sccm, and etching is performed.

According to a dry etching method using such a dry etching apparatus 1, a quartz substrate can be etched to a thickness of 10 µm. For example, a substrate having a thickness in the range of 50 to 150 µm can be etched on both sides at a high aspect ratio, such as a width of 1 µm and a depth in the range of 20 to 70 µm.

### EXAMPLE 1

In the present example, a quartz substrate was etched on both sides with an etching apparatus 1 illustrated in Fig. 1.

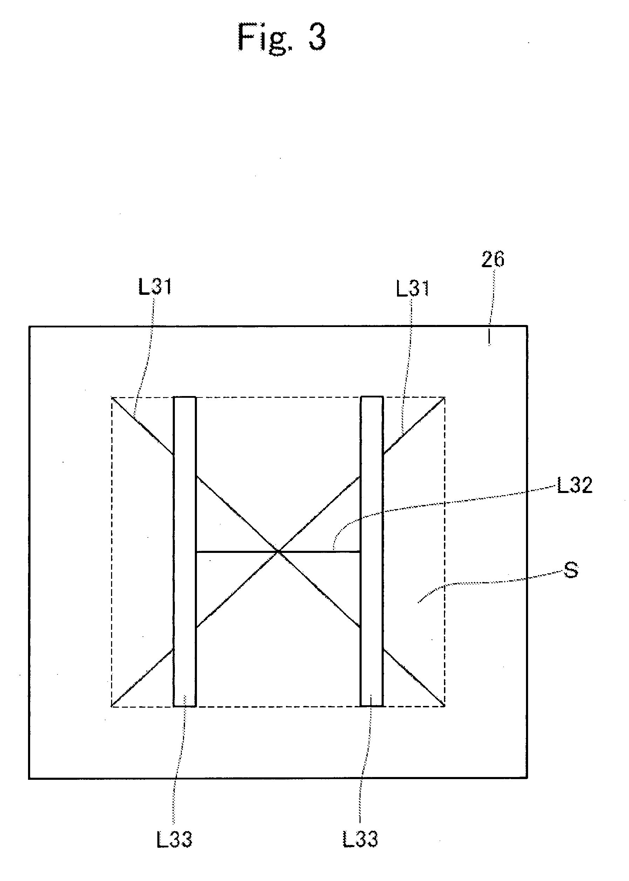

A thermal release sheet (Revalpha (trade name), thermal release temperature 170°C) having an adhesive layer on both sides manufactured by Nitto Denko Co. was prepared as a heat-conductive sheet 26. Slits having shapes illustrated in Fig. 3 were formed in the heat-conductive sheet 26. In Fig. 3, the dotted line represents a substrate S to be attached. The heat-conductive sheet 26 had two linear slits L31 corresponding to the diagonal lines of the substrate, a single linear slit L32 parallel to the lateral direction of the substrate and passing through the center of the substrate, and two rectangular slits L33 parallel to the direction of the stripes of a mask. The heat-conductive sheet 26 having these slits was attached to a silicon base acting as the base 27. Ni masks were formed on a quartz substrate S to be processed (having a thickness of 100 µm) at intervals of 400 µm. The substrate S was fixed on the heat-conductive sheet 26. The silicon base was then placed on an electrostatic chuck electrode 22 of the etching apparatus 1. Plasma was generated with a second high-frequency power source 43. 100 sccm of etching gas including C₄F₈ gas and Ar gas (Ar gas constituted 80% of the total flow rate of the etching gas) was introduced, and the substrate S to be processed was etched. Etching conditions included a first high-frequency power source (substrate side) 550 W, a second high-frequency power source (antenna side) 1800 W, a substrate set temperature of 10°C, and a pressure of 0.67 Pa.

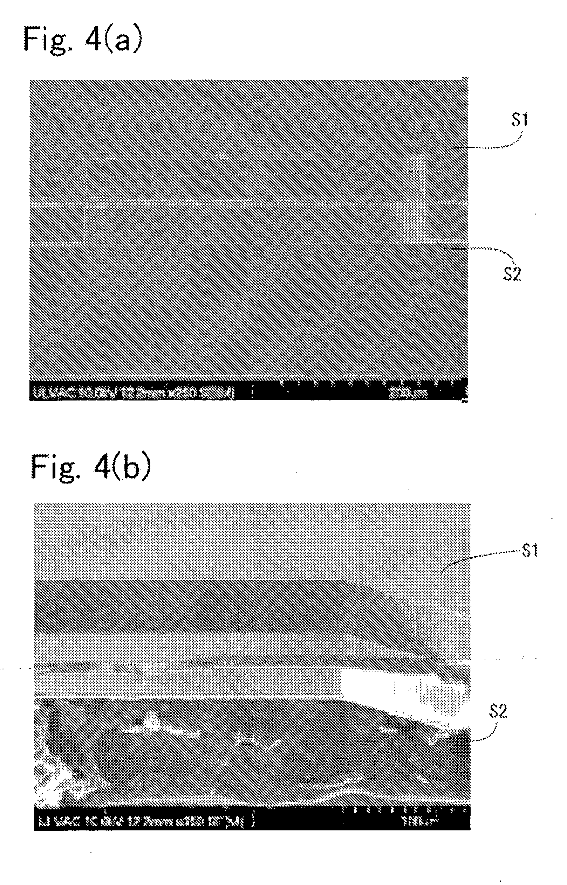

The quartz substrate was etched by approximately 45 µm while the etching gas was introduced for 50 minutes. The silicon base was then removed from the etching apparatus 1. The substrate S was detached from the heat-conductive sheet on a hot plate at 120°C. The substrate S was then reversed and was fixed on the heat-conductive sheet with an unetched surface facing upward. The substrate S was etched again by approximately 45 µm under the substantially same conditions while the etching gas was introduced for 50 minutes. Fig. 4(a) shows a cross-sectional SEM photograph of the resulting substrate, and 4(b) shows an SEM photograph of the substrate viewed from obliquely above.

Figs. 4(a) and 4(b) show that surfaces S1 and S2 of the substrate S were etched and that the substrate S was etched on both sides without a crack, leaving only a very thin central portion (approximately 10 µm).

### (COMPARATIVE EXAMPLE 1)

Etching was performed under the same conditions as in Example 1, except that the substrate was placed on the silicon base directly rather than through the heat-conductive sheet. After etching of a surface, the silicon base was removed, and a crack was observed in the substrate. The direct installation of the substrate on the base probably resulted in low thermal conductivity and insufficient cooling. The substrate was therefore subjected to high temperature to form a crack.

### (COMPARATIVE EXAMPLE 2)

Etching was performed under the same conditions as in Example 1, except that the substrate S was fixed on a heat-conductive paste applied to the silicon base without providing the heat-conductive sheet. After etching of the backside, the silicon base was removed, and a crack was observed in the substrate S. Gas bubbles in the paste were probably thermally expanded and caused a crack in the substrate S. Removal of the heat-conductive paste required ultrasonic cleaning in alcohol. After the ultrasonic cleaning, additional fine cracks formed in the substrate.

### (COMPARATIVE EXAMPLE 3)

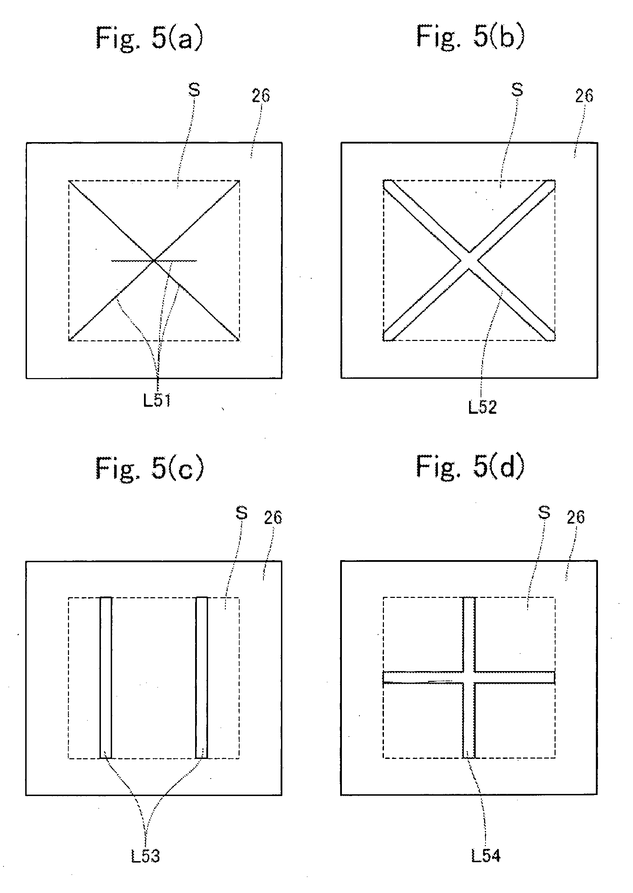

Etching was performed under the same conditions as in Example 1, except that the heat-conductive sheet had slits having the shapes illustrated in Fig. 5(a) (linear slits L51 on the diagonal lines of the substrate and a linear slit L51 parallel to a side of the substrate). After etching of a surface, the silicon base was removed, and it was observed that no crack formed in the substrate but a metal mask was detached.

### (COMPARATIVE EXAMPLE 4)

Etching was performed under the same conditions as in Example 1, except that the heat-conductive sheet had a slit having the shape illustrated in Fig. 5(b) (a polygonal slit L52 corresponding to the diagonal lines of the substrate). After etching of a surface, the silicon base was removed, and it was observed that a crack formed in the substrate and a metal mask was detached.

### (COMPARATIVE EXAMPLE 5)

Etching was performed under the same conditions as in Example 1, except that the heat-conductive sheet had slits having the shapes illustrated in Fig. 5(c) (two rectangular slits L53 parallel to the direction of the stripes of the mask). After etching of a surface, the silicon base was removed, and it was observed that a crack formed in the substrate and a metal mask was detached.

### (COMPARATIVE EXAMPLE 6)

Etching was performed under the same conditions as in Example 1, except that the heat-conductive sheet had a slit having the shape illustrated in Fig. 5(d) (a cross-shaped polygonal slit L54 passing through the center of the substrate). After etching of a surface, the silicon base was removed, and it was observed that a crack formed in the substrate and a metal mask was detached.

According to the above-described results demonstrate that only when the heat-conductive sheet having the slits in the shapes described in Example 1 is used, the quartz substrate can be etched on both sides with the etching apparatus 1.

### Industrial Applicability

According to a dry etching method of the present invention, a substrate can be stably etched on both sides. Thus, the present invention can be utilized in the semiconductor technical field.

### [Brief Description of Drawings]

Fig. 1 is a schematic view of a dry etching apparatus for use in a dry etching method according to the present invention.
Figs. 2(a) to 2(c) are schematic views illustrating a double-sided dry etching method according to the present invention.
Fig. 3 is a schematic view of the shape of slits in a heat-conductive sheet used in Example 1.
Figs. 4(a) and 4(b) are SEM photographs indicating the results of Example 1: 4(a) is a cross-sectional SEM photograph of a substrate, and 4(b) is an SEM photograph of the substrate viewed from obliquely above.
Figs. 5(a) to 5(d) are schematic views illustrating the shapes of slits in heat-conductive sheets used in Comparative Examples 3 to 6: 5(a) for Comparative Example 3, 5(b) for Comparative Example 4, 5(c) for Comparative Example 5, and 5(d) for Comparative Example 6.

### [Description of Reference Numerals]

- 1: etching apparatus
- 2: substrate table
- 3: etching gas-inlet means
- 11: vacuum chamber
- 12: evacuation means
- 13: substrate processing chamber
- 14: plasma generation chamber
- 15: top plate
- 21: substrate electrode
- 22: electrostatic chuck electrode
- 23: support
- 24: blocking capacitor
- 25: high-frequency power source
- 26: heat-conductive sheet
- 27: base
- 31: gas-inlet line
- 32: gas-flow control means
- 33: rare gas source
- 34: fluorocarbon gas source
- 41: magnetic field coil
- 42: antenna coil
- 42: high-frequency antenna coil
- 43: high-frequency power source
- S: substrate to be processed
- L31, L32, L33: slit

## Claims

1. A dry etching method comprising:
introducing an etching gas including a fluorocarbon gas and a rare gas into a vacuum chamber;
generating plasma in the vacuum chamber having a predetermined pressure; and
etching a substrate adhered on an adhesive surface of a heat-conductive sheet disposed on a substrate table which etching includes etching one side of the substrate;
detaching the substrate from the heat-conductive sheet and reversing the substrate;
adhering the one side on the adhesive surface of the heat-conductive sheet; and
etching the other side of the substrate under substantially same conditions as conditions for the one side.

2. The dry etching method according to claim 1, wherein the substrate is detached from the heat-conductive sheet by heating or UV irradiation.

3. The dry etching method according to any one of claims 1 to 2, wherein the substrate is a quartz substrate.

4. The dry etching method according to any one of claims 1 to 3, wherein the heat-conductive sheet has a slit.

5. The dry etching method according to any one of claims 1 to 4, wherein the flow rate of the rare gas ranges from 80% to 95% of the total flow rate of the etching gas.

6. The dry etching method according to any one of claims 1 to 5, wherein the rare gas is at least one of Ar, Kr, and Xe.

7. The dry etching method according to any one of claims 1 to 6, wherein the dry etching method is performed in a low-pressure process at 1 Pa or less.

8. The dry etching method according to claim 1, further comprising:
fixing the heat-conductive sheet on a base before the substrate is adhered on the adhesive surface of the heat-conductive sheet, wherein the substrate is a quartz substrate;
placing the base on the substrate table in the vacuum chamber before the etching gas including the fluorocarbon gas and the rare gas is introduced into the etching chamber;
forming a magnetic neutral line while maintaining the internal pressure of the vacuum chamber at 1 Pa or less; and
applying an electric field to generate plasma in the vacuum chamber before the one side of the substrate is etched and the substrate is detached from the heat-conductive sheet.

9. The dry etching method according to claim 8, wherein the flow rate of the rare gas ranges from 80% to 95% of the total flow rate of the etching gas, the rare gas is at least one of Ar, Kr, and Xe, the heat-conductive sheet has a slit, and the substrate is detached from the heat-conductive sheet by heating or UV irradiation.

## Patentansprüche

1. Trockenätzverfahren, Folgendes umfassend:
Einleiten eines Fluorkohlenstoffgas und Edelgas enthaltenden Ätzgases in eine Vakuumkammer;
Erzeugen von Plasma in der Vakuumkammer mit einem vorbestimmten Druck; und
Ätzen eines Substrats, das an einer Adhäsionsfläche einer wärmeleitfähigen Platte anhaftet, der auf einem Substrattisch angeordnet ist, welches Ätzen umfasst, eine Seite des Substrats zu ätzen;
Lösen des Substrats von der wärmeleitfähigen Platte und Umdrehen des Substrats;
Anhaften der einen Seite an der Adhäsionsfläche der wärmeleitfähigen Platte; und
Ätzen der anderen Seite des Substrats unter im Wesentlichen denselben Bedingungen wie für die eine Seite.

2. Trockenätzverfahren nach Anspruch 1, wobei das Substrat durch Erwärmen oder UV-Bestrahlung von der wärmeleitfähigen Platte gelöst wird.

3. Trockenätzverfahren nach einem der Ansprüche 1 bis 2, wobei es sich bei dem Substrat um ein Quarzsubstrat handelt.

4. Trockenätzverfahren nach einem der Ansprüche 1 bis 3, wobei die wärmeleitfähige Platte einen Schlitz hat.

5. Trockenätzverfahren nach einem der Ansprüche 1 bis 4, wobei der Durchfluss des Edelgases im Bereich von 80% bis 95% des Gesamtdurchflusses des Ätzgases liegt.

6. Trockenätzverfahren nach einem der Ansprüche 1 bis 5, wobei es sich bei dem Edelgas um Ar, Kr und/oder Xe handelt.

7. Trockenätzverfahren nach einem der Ansprüche 1 bis 6, wobei das Trockenätzverfahren in einem Niederdruckprozess bei 1 Pa oder weniger durchgeführt wird.

8. Trockenätzverfahren nach Anspruch 1, darüber hinaus umfassend:
Fixieren der wärmeleitfähigen Platte an einer Unterlage, bevor das Substrat an die Adhäsionsfläche der wärmeleitfähigen Platte angehaftet wird, wobei es sich bei dem Substrat um ein Quarzsubstrat handelt;
Anordnen der Unterlage auf dem Substrattisch in der Vakuumkammer, bevor das das Fluorkohlenstoffgas und das Edelgas enthaltende Ätzgas in die Ätzkammer eingeleitet wird;
Bilden einer magnetischen Neutrallinie, während der Innendruck der Vakuumkammer bei 1 Pa oder weniger gehalten wird; und
Anlegen eines elektrischen Feldes, um Plasma in der Vakuumkammer zu erzeugen, bevor die eine Seite des Substrats geätzt und das Substrat von der wärmeleitfähigen Platte gelöst wird.

9. Trockenätzverfahren nach Anspruch 8, wobei der Durchfluss des Edelgases im Bereich von 80% bis 95% des Gesamtdurchflusses des Ätzgases liegt, wobei es sich bei dem Edelgas um Ar, Kr und/oder Xe handelt, wobei die wärmeleitfähige Platte einen Schlitz hat und wobei das Substrat durch Erwärmen oder UV-Bestrahlung von der wärmeleitfähigen Platte gelöst wird.

## Revendications

1. Procédé de gravure sèche comprenant :
l'introduction d'un gaz de gravure incluant un gaz fluorocarboné et un gaz rare dans une chambre à vide ;
la génération de plasma dans la chambre à vide ayant une pression prédéterminée ; et
la gravure d'un substrat collé sur une surface adhésive d'une feuille thermoconductrice disposée sur une table à substrat, laquelle gravure inclut la gravure d'un côté du substrat ;
le détachement du substrat de la feuille thermoconductrice et le retournement du substrat ;
le collage de l'un côté sur la surface adhésive de la feuille thermoconductrice ; et
la gravure de l'autre côté du substrat dans des conditions sensiblement pareilles aux conditions prévalant pour l'un côté.

2. Le procédé de gravure sèche selon la revendication 1, dans lequel le substrat est détaché de la feuille thermoconductrice par chauffage ou irradiation aux UV.

3. Le procédé de gravure sèche selon l'une quelconque des revendications 1 à 2, dans lequel le substrat est un substrat de quartz.

4. Le procédé de gravure sèche selon l'une quelconque des revendications 1 à 3, dans lequel la feuille thermoconductrice a une fente.

5. Le procédé de gravure sèche selon l'une quelconque des revendications 1 à 4, dans lequel le débit du gaz rare est compris entre 80% et 95% du débit total du gaz de gravure.

6. Le procédé de gravure sèche selon l'une quelconque des revendications 1 à 5, dans lequel le gaz rare est au moins un gaz parmi Ar, Kr, et Xe.

7. Le procédé de gravure sèche selon l'une quelconque des revendications 1 à 6, dans lequel le procédé de gravure sèche est réalisé dans un processus à basse pression à 1 Pa ou moins.

8. Le procédé de gravure sèche selon la revendication 1, comprenant en outre :
la fixation de la feuille thermoconductrice sur une base avant que le substrat soit collé sur la surface adhésive de la feuille thermoconductrice, le substrat étant un substrat de quartz ;
le placement de la base sur la table à substrat dans la chambre à vide avant que le gaz de gravure incluant le gaz fluorocarboné et le gaz rare soit introduit dans la chambre de gravure ;
la formation d'une ligne magnétique neutre tout en maintenant la pression interne de la chambre à vide à 1 Pa ou moins ; et
l'application d'un champ électrique pour générer du plasma dans la chambre à vide avant que l'un côté du substrat soit gravé et que le substrat soit détaché de la feuille thermoconductrice.

9. Le procédé de gravure sèche selon la revendication 8, dans lequel le débit du gaz rare est compris entre 80% et 95% du débit total du gaz de gravure, le gaz rare est au moins un gaz parmi Ar, Kr, et Xe, la feuille thermoconductrice a une fente, et le substrat est détaché de la feuille thermoconductrice par chauffage ou irradiation aux UV.
